# EUROPÄISCHE PATENTSCHRIFT

(11) **EP 0 698 968 B1**
(45) Veröffentlichungstag und Bekanntmachung des Hinweises auf die Patenterteilung: **03.05.2000**
(21) Anmeldenummer: 95110243.3
(22) Anmeldetag: 30.06.1995
(51) Int. Cl.: H03L 7/07

(54) **Verfahren zum Synchronisieren der Ausgangsfrequenzen eines Taktgenerators**
Process to synchronise the output frequencies of a clock generator
Procédé pour synchroniser les fréquences de sortie d'un générateur d'horloge

(30) Priorität: 24.08.1994 DE 4431415
(43) Veröffentlichungstag der Anmeldung: 28.02.1996
(73) Patentinhaber: DeTeWe - Deutsche Telephonwerke Aktiengesellschaft & Co., 10997 Berlin (DE)
(72) Erfinder: Egbers, Jochen, D-12247 Berlin (DE); Goerge, Rainer, D-12161 Berlin (DE); Huhn, Karl-Eckardt, D-13465 Berlin (DE); Riehm, Nikolaus, D-22359 Hamburg (DE)
(74) Vertreter: Ninnemann, Detlef, Dipl.-Ing.

(56) Entgegenhaltungen:
- EP-A- 0 509 706
- US-A- 5 144 254
- US-A- 5 353 311
- IBM TECHNICAL DISCLOSURE BULLETIN, Bd.33, Nr.4, 1. September 1990, NEW YORK,US Seiten 189 - 191 'PHASE NOISE REDUCTION USING CASCADED VARIABLE FREQUENCY OSCILLATORS'

## Beschreibung

Die Erfindung betrifft ein Verfahren und eine Anordnung zum Synchronisieren der Ausgangsfrequenzen eines Taktgenerators einer Anlage auf externe Eingangsfrequenzen hoher Genauigkeit.

Aus der US-A-5,353,311, veröffentlicht mit Dokument JP-A-5 336 181 am 17.12.93, ist ein Funksender mit einem digitalen Phasenregelkreis zur Erzeugung von Frequenzsprungsignalen aus zwei Eingangssignalen, nämlich aus digitalen Frequenzdaten und einer Referenzfrequenz bekannt. Die Referenzfrequenz bildet die genaue Basis der am Ausgang des digitalen Phasenregelkreises abgegebenen mehreren Ausgangsfrequenzen durch eine digitale Verknüpfung der beiden Eingangssignale, indem eine Speicheradresse durch den mit der Referenzfrequenz verknüpften Wert der digitalen Frequenzdaten angesprochen und eine entsprechende Ausgangsfrequenz vom digitalen Phasenregelkreis abgegeben wird. Dabei werden Phasensprünge im Ausgangssignal durch einen nachgeschalteten analogen Phasenregelkreis ausgeregelt.

Aus der US-A-5,144,254 ist ein Verfahren zum Erzeugen einer beliebigen Ausgangsfrequenz mit einem Taktgenerator bekannt, der zwei hintereinandergeschaltete Phasenregelkreise mit Rückkopplungszweigen, eine Referenzfrequenzquelle und einen Mikroprozessor als Rechen- und Steuereinheit aufweist. Dabei werden in den Rückkopplungszweigen der Phasenregelkreise angeordnete programmierbare Frequenzteiler und damit eine intern erzeugte Referenzfrequenz durch den Mikroprozessor eingestellt, um eine Ausgangsfrequenz aus der Referenzfrequenz zu erzeugen, die möglichst genau mit einer gewünschte Soll-Frequenz übereinstimmt.

Aufgabe der vorliegenden Erfindung ist es, ein Verfahren anzugeben, mit dem in einem Taktgenerator mehrere zu einer Eingangsfrequenz hoher Genauigkeit synchrone, jitterreduzierte Ausgangsfrequenzen erzeugt werden und eine Phasenwandererkennung sowie die Überbrückung von Ausfällen der eingangsseitig angebotenen Takte gewährleistet wird. Weiterhin soll die Herstellung des Taktgenerators den Einsatz wirtschaftlicher Bauelemente sowie eine weitgehende Integration dieser Bauelemente gestatten.

Diese Aufgabe wird erfindungsgemäß durch ein Verfahren zum Synchronisieren der Ausgangsfrequenzen eines Taktgenerators einer Anlage auf externe Eingangsfrequenzen hoher Genauigkeit mit folgender Merkmalskombination gelöst:

Ein Frequenzgenerator (FGEN) legt eine relativ ungenaue Arbeitsfrequenz (FWORK) an einen Frequenzsynthesizer (FSYN), einen Frequenzbewerter (FB) und einen digitalen Phasenregelkreis (DPLL) an. Der Frequenzsynthesizer (FSYN) bewertet zusammen mit dem digitalen Phasenregelkreis (DPLL) und einem steuernden Mikroprozessor die Arbeitsfrequenz (FWORK) im Vergleich zu den externen zugeführten Eingangsfrequenzen (FE) hoher Genauigkeit, während der Frequenzbewerter (FB) die externen Eingangsfrequenzen (FE) in den vom Mikroprozessor vorgegebenen Bereichsgrenzen überprüft und in eine Normfrequenz (FNOR) umwandelt. Der digitale Phasenregelkreis (DPLL) gibt eine Signalfrequenz (SIP), die aus der Arbeitsfrequenz (FWORK) und vom Frequenzsynthesizer (FSYN) ermittelten Korrekturwerten gebildet wird, synchron zur Normfrequenz (FNOR) geregelt ab. Ein Frequenzteiler (FT) erzeugt die systeminternen Ausgangsfrequenzen (FA) und ein dem Frequenzteiler (FT) vorgeschalteter analoger Phasenregelkreis (APLL) nimmt Korrekturen an der Signalfrequenz (SIP) vor, die dem Verhindern von Zeitsprüngen der Ausgangsfrequenzen (FA) dienen.

Die erfindungsgemäße Lösung schafft ein Verfahren zum Synchronisieren der von einem Taktgenerator abgegebenen Ausgangsfrequenzen auf extern zugeführte Eingangsfrequenzen mit jitterreduzierten Ausgangsfrequenzen sowie einer Phasenwandererkennung und einer Überbrückung von Ausfällen der angebotenen Eingangstakte.

Vorteilhafte Ausgestaltungen und Weiterbildungen des erfindungsgemäßen Verfahrens sind Gegenstand der Unteransprüche 2 bis 6.

Eine Anordnung zum Synchronisieren der Ausgangsfrequenzen eines Taktgenerators einer Anlage auf externe Eingangsfrequenzen hoher Genauigkeit weist einen Frequenzgenerator (FGEN) auf, dessen Ausgang eine relativ ungenaue Arbeitsfrequenz (FWORK) abgibt und mit dem Eingang eines Frequenzsynthesizers (FSYN), eines Frequenzbewerters (FB) und eines digitalen Phasenregelkreis (DPLL) verbunden ist, wobei der Frequenzsynthesizer (FSYN) und der digitale Phasenregelkreis (DPLL) wechselseitig miteinander und mit einem steuernden Mikroprozessor verbunden sind und die Arbeitsfrequenz (FWORK) im Vergleich zu den externen Eingangsfrequenzen (FE) hoher Genauigkeit bewerten. Der eingangsseitig mit den externen Eingangsfrequenzen (FE) beaufschlagte Frequenzbewerter (FB) überprüft die externen Eingangsfrequenzen (FE) in den vom Mikroprozessor vorgegebenen Bereichsgrenzen und gibt an seinem Ausgang eine Normfrequenz (FNOR) an den digitalen Phasenregelkreis (DPLL) ab, dessen Ausgang eine aus der Arbeitsfrequenz (FWORK) und den vom Frequenzsynthesizer (FSYN) ermittelten Korrekturwerten gebildete und zur Normfrequenz (FNOR) synchrone Signalfrequenz (SIP) abgibt und mit dem Eingang eines analogen Phasenregelkreis (APLL) verbunden ist, dessen Ausgang mit einem die systeminternen Ausgangsfrequenzen (FA) erzeugenden Frequenzteiler (FT) verbunden ist.

Vorzugsweise sind der Frequenzsynthesizer (FSYN), der Frequenzbewerter (FB), der digitale Phasenregelkreis (DPLL) und der Frequenzteiler (FT) auf einem Taktgenerator-Schaltkreis (TG-ASIC) integriert.

Die erfindungsgemäße Anordnung der Bauelemente des Taktgenerators ermöglicht die Verwendung kostengünstiger Quarz-Oszillatoren mit geringen Genauigkeitsanforderungen, einem geringen Raumbedarf durch die Möglichkeit der Integration großer Teile der Schaltungsanordnung auf einem Baustein und die Nutzung eines vorhandenen Mikroprozessors einer Anlage, der nur gering belastet wird. Ferner kann durch einen externen Schaltkreis eine Rückmeldung zur Wander-Bewertung der Eingangsfrequenz ermöglicht werden.

Die Erfindung wird nachfolgend anhand einer aus drei Figuren bestehenden Zeichnung näher erläutert. Darin zeigen die
- Fig. 1: das Blockschaltbild eines Taktgenerators, die
- Fig. 2: das Beispiel der Integration von Teilen des Taktgenerators und die
- Fig. 3: das Ablaufdiagramm für den Taktgenerator.

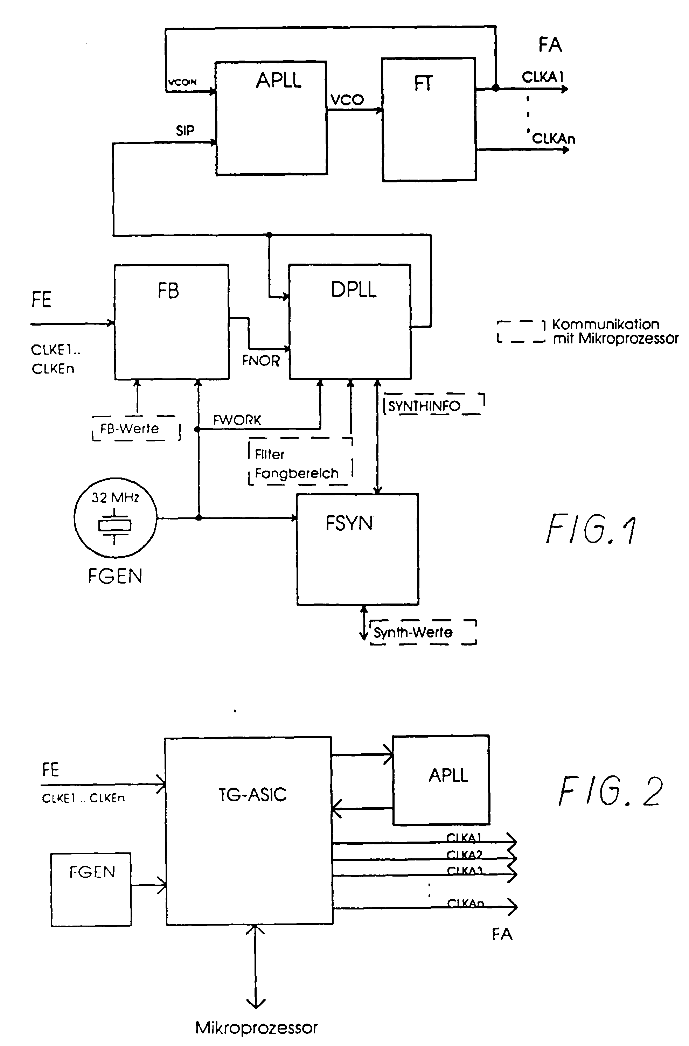

Der Taktgenerator nach Fig. 1 setzt sich aus einem Frequenzgenerator FGEN, einem Frequenzbewerter FB, einem digitalen Phasenregelkreis DPLL, einem analogen Phasenregelkreis APLL, einem Frequenzsynthesizer FSYN und einem Frequenzteiler FT zusammen. Der Taktgenerator erzeugt mehrere zu einer Eingangsfrequenz FE hoher Genauigkeit synchrone, jitterreduzierte Ausgangsfrequenzen FA.

Die Einstellung des Taktgenerators wird über einen in z. B. einer Telekommunikations-Anlage vorhandenen Mikroprozessor gesteuert, von dem in den Figuren 1 bis 3 nur die Meldungseingänge bzw. Meldungsausgänge angedeutet sind.

Der Frequenzgenerator FGEN dient dem Erzeugen einer Arbeitsfrequenz FWORK mit einer relativ ungenauen Frequenz, zum Beispiel typisch 32 MHz +/- 100 ppm. Diese Arbeitsfrequenz FWORK ist die Grundfrequenz für die gesamte Taktgenerator-Schaltung. Sie wird an den Frequenzbewerter FB, den Frequenzsynthesizer FSYN und den digitalen Phasenregelkreis DPLL gelegt. Für die Anwendung kostengünstiger Quarz-Oszillatoren sind lediglich deren Kurzzeitalterung und Temperaturverhalten von Bedeutung.

Der Frequenzsynthesizer FSYN ist mit dem digitalen Phasenregelkreis DPLL und dem steuernden Mikroprozessor z. B der Telekommunikations-Anlage verbunden. Der Frequenzsynthesizer FSYN ermittelt unter Berücksichtigung der Frequenzgenauigkeit der Arbeitsfrequenz FWORK die Korrekturwerte für den digitalen Phasenregelkreis DPLL. Die Information über diese Korrekturwerte wird z. B. vom Mikroprozessor der Telekommunikations-Anlage als Initialisierungswert für den Frequenzsynthesizer FSYN abrufbar gespeichert.

Fällt die Eingangsfrequenz FE aus, oder wird z. B. die Telekommunikations-Anlage initialisiert, wird über den Mikroprozessor MP der zuletzt abgespeicherte Wert in den Frequenzsynthesizer FSYN geladen. Diese Vorgehensweise gewährleistet, daß die zuvor erreichte Genauigkeit der Ausgangsfrequenz FA ohne Frequenz- und Phasensprung vom Taktgenerator gehalten wird.

Der einstellbare Frequenzbewerter FB prüft die Eingangsfrequenz FE bei jeder Neuanschaltung eines anderen Taktes auf die Einhaltung der Frequenzgrenzen über einen bestimmten Zeitraum, beispielsweise 2 ms, und normiert für die weitere Bearbeitung die Eingangsfrequenz FE auf eine Normfrequenz FNOR, beispielsweise 8 kHz. Durch die Einführung einer Normfrequenz FNOR ist der Taktgenerator unabhängig von der jeweils angebotenen Eingangsfrequenz FE, z. B. typisch CLKE1 = 1,536 MHz oder CLKE2 = 2,048 MHz.

Die für den Taktgenerator gültigen Bereiche der Eingangsfrequenzen FE werden durch den Mikroprozessor der z. B. Telekommunikations-Anlage vorgegeben und im Frequenzbewerter FB programmiert.

Der digitale Phasenregelkreis DPLL regelt seine ausgegebene Signalfrequenz SIP derart, daß sie immer synchron der Normfrequenz FNOR ist. Damit wird der Phasenjitter der Eingangsfrequenz FE reduziert. Die Veränderung der Signalfrequenz SIP des digitalen Phasenregelkreises DPLL wird durch Einfügen oder Weglassen von Impulsen des Ausgangsbitstromes erreicht. Hierzu werden die Informationen des Frequenzsynthesizers FSYN und die des digitalen Phasenregelkreises DPLL zusammengefaßt und zum Steuern des Bitstromes verwendet. Die Filtereigenschaften und der Fang- bzw. Haltebereich des digitalen Phasenregelkreises DPLL sind durch den Mikroprozessor der z. B. Telekommunikations-Anlage programmierbar.

Der analoge Phasenregelkreis APLL dient dem Verhindern von Zeitsprüngen der Ausgangsfrequenzen FA durch Korrekturen an der Signalfrequenz SIP des digitalen Phasenregelkreises DPLL. Beim Einschalten des Taktgenerators nach einem Rücksetzen sorgt der analoge Phasenregelkreis APLL für eine Ausgangsfrequenz FA, solange der digitale Phasenregelkreis DPLL noch nicht betriebsbereit ist.

Der Frequenzteiler FT setzt die hohe Frequenz VCO des analogen Phasenregelkreises APLL in die systemintern benötigten Ausgangsfrequenzen FA um, z. B. CLKA1 = 2,048 MHz und CLKA2 = 8,192 MHz.

Wie der Figur 2 entnehmbar ist, lassen sich in wirtschaftlicher Weise der Frequenzbewerter FB, der digitale Phasenregelkreis DPLL, der Frequenzsynthesizer FSYN und der Frequenzteiler FT zu einem Taktgenerator-Schaltkreis TG-ASIC integrieren.

Als Frequenzgenerator FGEN dient, wie bereits erwähnt, ein Quarz-Oszillator hoher Frequenz mit geringer Genauigkeit.

Als analoger Phasenregelkreis APLL wird ein kostengünstiger Standard-Schaltkreis eingesetzt.

Der Taktgenerator-Schaltkreis TG-ASIC, der Frequenzgenerator FGEN und der analoge Phasenregelkreis APLL können auch in einem kundenspezifischen Baustein integriert werden.

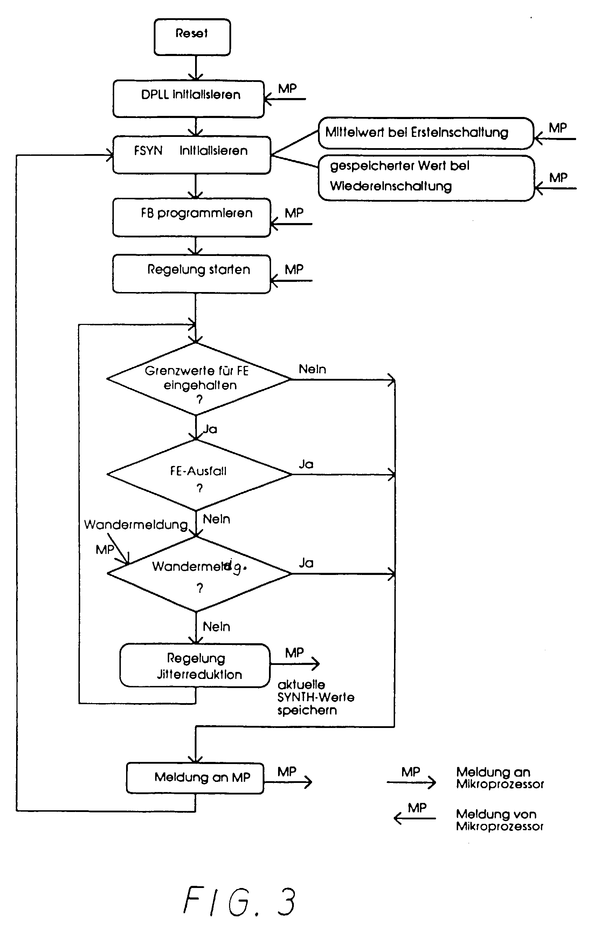

In der Figur 3 ist das Ablaufdiagramm des Taktgenerators dargestellt, aus dem dessen Funktion ersichtlich ist. Nach dem Rücksetzen in die Ausgangslage werden dem digitalen Phasenregelkreis DPLL die Filtereigenschaften und der Fang- bzw. Haltebereich vom Mikroprozessor MP übermittelt. Ebenso werden dem Frequenzsynthesizer FSYN die Informationen über die zuletzt erreichte Ausgangsfrequenz bzw. die Initialisierungswerte bei der Erstanschaltung mitgeteilt. Dann werden durch den Mikroprozessor MP dem Frequenzbewerter FB die gültigen Frequenzbereiche für die anliegenden Eingangsfrequenzen FE übermittelt. Nach dem Start durch den Mikroprozessors MP wird die Regelung, wie in der Fig. 3 dargestellt, vorgenommen. Dabei werden auch eine Wander-Bewertung der Eingangsfrequenz FE durch Ausnutzung einer Rückmeldung eines externen Schaltkreises berücksichtigt und ein Jitter reduziert.

Nach Erreichen des Synchronzustandes werden die Grenzen des Regelbereiches durch den Taktgenerator geprüft. Ein Ausfall der Eingangsfrequenz FE wird durch den Taktgenerator erkannt. Solange der Taktgenerator synchron ist, werden regelmäßig die aktuellen Einstellwerte durch den Mikroprozessor MP ausgelesen, um sie beim Neustart oder beim Ausfall der Eingangsfrequenz FE als neue Initialisierungswerte für den Frequenzsynthesizer FSYN zu verwenden.

## Patentansprüche

1. Verfahren zum Synchronisieren der Ausgangsfrequenzen eines Taktgenerators einer Anlage auf externe Eingangsfrequenzen hoher Genauigkeit,
**dadurch gekennzeichnet**,
daß ein Frequenzgenerator (FGEN) eine relativ ungenaue Arbeitsfrequenz (FWORK) an einen Frequenzsynthesizer (FSYN), einen Frequenzbewerter (FB) und einen digitalen Phasenregelkreis (DPLL) legt, daß der Frequenzsynthesizer (FSYN) zusammen mit dem digitalen Phasenregelkreis (DPLL) und einem steuernden Mikroprozessor die Arbeitsfrequenz (FWORK) im Vergleich zu den externen Eingangsfrequenzen (FE) hoher Genauigkeit bewertet, daß der Frequenzbewerter (FB) die externen Eingangsfrequenzen (FE) in den vom Mikroprozessor vorgegebenen Bereichsgrenzen überprüft und in eine Normfrequenz (FNOR) umwandelt, daß der digitale Phasenregelkreis (DPLL) aus der Arbeitsfrequenz (FWORK) und vom Frequenzsynthesizer (FSYN) ermittelten Korrekturwerten eine Signalfrequenz (SIP) synchron zur Normfrequenz (FNOR) geregelt abgibt, daß ein Frequenzteiler (FT) die systeminternen Ausgangsfrequenzen (FA) erzeugt, und daß ein vorgeschalteter analoger Phasenregelkreis (APLL) Korrekturen an der Signalfrequenz (SIP) vornimmt, die dem Verhindern von Zeitsprüngen der Ausgangsfrequenzen (FA) dienen.

2. Verfahren nach Anspruch 1, **dadurch gekennzeichnet**, daß zur Steuerung des Taktgenerators ein beliebiger z. B. in einer Telekommunikations-Anlage vorhandener Mikroprozessor verwendet wird.

3. Verfahren nach Anspruch 1 und 2, **dadurch gekennzeichnet**, daß bei Ausfall der Eingangsfrequenz (FE) der Taktgenerator mittels der zuletzt durch den Frequenzsynthesizer (FSYN) ermittelten Werte die zuvor erreichte Genauigkeit der Ausgangsfrequenz (FA) ohne Frequenz- und Phasensprung beibehält.

4. Verfahren nach Anspruch 1 und 2, **dadurch gekennzeichnet**, daß die Arbeitsfrequenz (FWORK) von einem Quarzoszillator geringer Genauigkeit des Frequenzgenerators (FGEN) erzeugt wird.

5. Verfahren nach Anspruch 1 und 2, **dadurch gekennzeichnet**, daß beim Umsetzen der Arbeitsfrequenz (FWORK) in eine genaue Frequenz die vom Frequenzsynthesizer (FSYN) ermittelten Korrekturwerte im verwendeten Mikroprozessor gespeichert werden.

6. Verfahren nach Anspruch 1 und 2, **dadurch gekennzeichnet**, daß der Frequenzbewerter (FB) bei Neueinschalten des Taktgenerators die Eingangsfrequenz (FE) während eines bestimmten Zeitraumes auf das Einhalten vorgegebener Frequenzgrenzen prüft.

7. Anordnung zum Synchronisieren der Ausgangsfrequenzen eines Taktgenerators einer Anlage auf externe Eingangsfrequenzen hoher Genauigkeit dadurch gekennzeichnet, daß die Anlage einen Frequenzgenerator (FGEN) aufweist, dessen Ausgang eine relativ ungenaue Arbeitsfrequenz (FWORK) abgibt und mit dem Eingang eines Frequenzsynthesizers (FSYN), eines Frequenzbewerters (FB) und eines digitalen Phasenregelkreis (DPLL) verbunden ist, wobei der Frequenzsynthesizer (FSYN) und der digitale Phasenregelkreis (DPLL) wechselseitig miteinander und mit einem steuernden Mikroprozessor verbunden sind und die Arbeitsfrequenz (FWORK) im Vergleich zu den externen Eingangsfrequenzen (FE) hoher Genauigkeit bewerten, daß der eingangsseitig mit den externen Eingangsfrequenzen (FE) beaufschlagte Frequenzbewerter (FB) die externen Eingangsfrequenzen (FE) in den vom Mikroprozessor vorgegebenen Bereichsgrenzen überprüft und an seinem Ausgang eine Normfrequenz (FNOR) an den digitalen Phasenregelkreis (DPLL) abgibt, dessen Ausgang eine aus der Arbeitsfrequenz (FWORK) und den vom Frequenzsynthesizer (FSYN) ermittelten Korrekturwerten gebildete und zur Normfrequenz (FNOR) synchrone Signalfrequenz (SIP) abgibt und mit dem Eingang eines analogen Phasenregelkreis (APLL) verbunden ist, dessen Ausgang mit einem die systeminternen Ausgangsfrequenzen (FA) erzeugenden Frequenzteiler (FT) verbunden ist.

8. Anordnung nach Anspruch 7, **dadurch gekennzeichnet**, daß der Frequenzsynthesizer (FSYN), der Frequenzbewerter (FB), der digitale Phasenregelkreis (DPLL) und der Frequenzteiler (FT) auf einem Taktgenerator-Schaltkreis (TG-ASIC) integriert sind.

## Claims

1. A process to synchronise the output frequencies of a clock generator of a device to external input frequencies of high precision
characterised in that
a frequency generator (FGEN) places a relatively imprecise working frequency (FWORK) on a frequency synthesiser (FSYN), a frequency evaluator (FB) and a digital phase control circuit (DPLL), whereby the frequency synthesiser (FSYN) together with the digital phase control circuit (DPLL) and a controlling microprocessor evaluates the working frequency (FWORK) in comparison with the external input frequencies (FE) of high precision, whereby the frequency evaluator (FB) checks the external input frequencies (FE) in the field boundaries given by the microprocessor and converts them into a norm frequency (FNOR), whereby the digital phase control circuit (DPLL) emits a signal frequency (SIP) from the working frequency (FWORK) and correction values determined by the frequency synthesiser (FSYN), whereby the signal frequency (SIP) is emitted in a regulated way and synchronously to the norm frequency (FNOR), whereby a frequency divider (FT) produces the system-internal output frequencies (FA), and whereby a previously switched-on analog phase control circuit (APLL) performs corrections on the signal frequency (SIP), which serve to prevent time leaps of the output frequencies (FA) .

2. A process according to Claim 1 characterised in that for the purpose of controlling the clock generator, any microprocessor, e.g. existing in a telecommunications installation, is used.

3. A process according to Claim 1 and Claim 2 characterised in that in the event of interruption of the input frequency (FE), the clock generator maintains the previously achieved precision of the output frequency (FA) without frequency and phase leaps, whereby this is achieved by means of the last values determined through the frequency synthesiser (FSYN).

4. A process according to Claim 1 and Claim 2 characterised in that the working frequency (FWORK) is produced by a quartz oscillator of low precision of the frequency generator (FGEN).

5. A process according to Claim 1 and Claim 2 characterised in that upon conversion of the working frequency (FWORK) into a precise frequency, the correction values determined by the frequency synthesiser (FSYN) are stored in the microprocessor which is used.

6. A process according to Claim 1 and Claim 2 characterised in that when the clock generator is switched on, the frequency evaluator (FB) checks the input frequency (FE) during a certain time period for the maintaining of specified frequency boundaries.

7. A device to synchronise the output frequencies of a clock generator of an installation to external input frequencies of high precision characterised in that the installation has a frequency generator (FGEN), the output of which emits a relatively imprecise working frequency (FWORK) and is connected to the input of a frequency synthesiser (FSYN), of a frequency evaluator (FB) and of a digital phase control circuit (DPLL), whereby the frequency synthesiser (FSYN) and the digital phase control circuit (DPLL) are reciprocally connected to each other and to a controlling microprocessor and evaluate the working frequency (FWORK) in comparison with the external input frequencies (FE) of high precision, whereby the frequency evaluator (FB) which on the input side contacts the external input frequencies (FE) checks the external input frequencies (FE) in the field boundaries given by the microprocessor, and at its output emits a norm frequency (FNOR) to the digital phase control circuit (DPLL), the output of which emits a signal frequency (SIP) which is synchronous to the norm frequency (FNOR) and is formed by the working frequency (FWORK) and the correction values determined by the frequency synthesiser (FSYN), and is connected to the input of an analog phase control circuit (APLL), the output of which is connected to a frequency divider (FT) producing the system-internal output frequencies (FA).

8. A device according to Claim 7 characterised in that the frequency synthesiser (FSYN), the frequency evaluator (FB), the digital phase control circuit (DPLL) and the frequency divider (FT) are integrated on a clock generator switching circuit (TG-ASIC).

## Revendications

1. Procédé pour synchroniser les fréquences de sortie d'un générateur de cadence d'une installation sur des fréquences externes d'entrée de grande précision,
caractérisé en ce
que le générateur de fréquence (FGEN) applique une fréquence de travail relativement peu précise (FWORK) à un synthétiseur de fréquence (FSYN), à un circuit (FB) d'évaluation de fréquences et à un circuit numérique de régulation de phase (DPLL), que le synthétiseur de fréquence (FSYN) évalue, conjointement avec le circuit numérique de régulation de phase (DPLL) et un microprocesseur de commande, la fréquence de travail (FWORK) par comparaison aux fréquences externes d'entrée (FE) de grande précision, que le circuit (FB) d'évaluation de fréquences contrôle les fréquences externes d'entrée (FE) dans les limites de gamme prédéterminées par le microprocesseur et les amène par conversion à une fréquence normalisée (FNOR), que le circuit numérique de régulation de phase (DPLL) délivre, à partir de la fréquence de travail (FWORK) et valeurs de correction déterminées par le synthétiseur de fréquence (FSYN), une fréquence de signal (SIP), d'une manière réglée de façon synchrone sur la fréquence normalisée (FNOR), qu'un diviseur de fréquence (FT) produit les fréquences de sortie (FA) internes au système et qu'un circuit analogique de régulation de phase (APLL) branché en amont applique à la fréquence de signal (SIP), des corrections qui sont utilisées pour empêcher des variations brusques dans le temps des fréquences de sortie (FA).

2. Procédé selon la revendication 1, caractérisé en ce que pour la commande du générateur de cadence, on utilise n'importe quel microprocesseur existant par exemple dans une installation de télécommunication.

3. Procédé selon les revendications 1 et 2, caractérisé en ce que dans le cas d'une défaillance de la fréquence d'entrée (FE), le générateur de cadence maintient, au moyen des valeurs déterminées en dernier lieu par le synthétiseur de fréquence (FSYN), la précision obtenue auparavant de la fréquence de sortie (FA) sans saut de fréquence ni saut de phase.

4. Procédé selon les revendications 1 et 2, caractérisé en ce que la fréquence de travail (FWORK) est produite par un oscillateur à quartz de faible précision du générateur de fréquence (FGEN).

5. Procédé selon les revendications 1 et 2, caractérisé en ce que lors de la conversion de la fréquence de travail (FWORK) en une fréquence précise, les valeurs de correction déterminées par le synthétiseur de fréquence (FSYN) sont mémorisées dans le microprocesseur utilisé.

6. Procédé selon les revendications 1 et 2, caractérisé en ce que lors d'une nouvelle activation du générateur de cadence, le circuit (FB) d'évaluation de fréquences contrôle la fréquence d'entrée (FE) pendant un intervalle de temps déterminé pour déterminer si les limites prédéterminées de fréquence sont respectées.

7. Dispositif pour synchroniser les fréquences de sortie d'un générateur de cadence d'une installation sur des fréquences externes d'entrée de grande précision, caractérisé en ce que l'installation comporte un générateur de fréquence (FGEN) dont la sortie délivre une fréquence de travail relativement peu précise (FWORK) et est reliée à l'entrée d'un synthétiseur de fréquence (FSYN), d'un circuit (FB) d'évaluation de fréquences et d'un circuit numérique de régulation de phase (DPLL), et dans lequel le synthétiseur de fréquence (FSYN) et le circuit numérique de régulation de phase (DPLL) sont reliés réciproquement entre eux et à un microprocesseur de commande, et évaluent la fréquence de travail (FWORK) par rapport au fréquences externes d'entrée (FE) de grande précision, que le circuit (FB) d'évaluation de fréquences, qui est chargée sur le côté entrée par les fréquences externes d'entrée (FE), contrôle les fréquences externes d'entrée (FE) dans les limites de gammes prédéterminées par le microprocesseur et délivre sur sa sortie une fréquence normalisée (FNOR) au circuit numérique de régulation de phase (DPLL), dont la sortie délivre une fréquence de signal (SIP), qui est formée à partir de la fréquence de travail (FWORK) et à partir des valeurs de correction déterminées par le synthétiseur de fréquence (FSYN) et est synchrone avec la fréquence normalisée (FNOR) et est reliée à l'entrée d'un circuit analogique de régulation de phase (APLL), dont la sortie est reliée à un diviseur de fréquence (FT) qui produit les fréquences de sortie (FA) internes au système.

8. Dispositif selon la revendication 7, caractérisé en ce que le synthétiseur de fréquence (FSYN), le circuit (FB) d'évaluation de fréquences, le circuit numérique de régulation de phase (DPLL) et le diviseur de fréquence (FT) sont intégrés dans un circuit (TG-ASIC) du générateur de cadence.
